(19) **Europäisches Patentamt**

**European Patent Office**

**Office européen des brevets**

(11) **EP 1 292 889 B1**

(12) **FASCICULE DE BREVET EUROPEEN**

(45) Date de publication et mention
de la délivrance du brevet:
**19.05.2004 Bulletin 2004/21**

(51) Int Cl.⁷: **G06F 11/10**

(21) Numéro de dépôt: **01938350.4**

(86) Numéro de dépôt international:
**PCT/FR2001/001634**

(22) Date de dépôt: **28.05.2001**

(87) Numéro de publication internationale:
**WO 2001/097032 (20.12.2001 Gazette 2001/51)**

(54) **MEMOIRE EEPROM SECURISEE COMPRENANT UN CIRCUIT DE CORRECTION D'ERREUR**

GESICHERTER EEPROM-SPEICHER MIT FEHLERKORREKTURSCHALTUNG

SECURE EEPROM COMPRISING AN ERROR CORRECTION CIRCUIT

(84) Etats contractants désignés:
**DE FR GB IT**

(30) Priorité: **13.06.2000 FR 0007479**

(43) Date de publication de la demande:
**19.03.2003 Bulletin 2003/12**

(73) Titulaire: **STMicroelectronics S.A.**
**92120 Montrouge (FR)**

(72) Inventeur: **WUIDART, Sylvie**
**F-83910 Pourrieres (FR)**

(74) Mandataire: **Marchand, André**
**OMNIPAT,**
**24 Place des Martyrs de la Résistance**
**13100 Aix-en-Provence (FR)**

(56) Documents cités:
**DE-A- 19 630 918        FR-A- 2 687 811**
**US-A- 5 535 162         US-A- 5 999 447**

## Description

La présente invention concerne les mémoires EEPROM comportant une zone sécurisée non effaçable, notamment les mémoires EEPROM pour circuits intégrés de carte à puce.

La présente invention concerne plus particulièrement l'intégration dans de telles mémoires d'un circuit de correction d'erreur.

Les mémoires effaçables et programmables électriquement présentes dans les circuits intégrés de carte à puce sont généralement pourvues d'une zone mémoire protégée programmable mais non effaçable, destinée à recevoir des bits OTP, c'est-à-dire des bits dont la valeur ne peut être modifiée que dans un sens. Ainsi, en attribuant par convention la valeur "0" à un bit effacé et la valeur "1" à un bit programmé, un bit OTP se distingue d'un bit ordinaire en ce qu'il peut être mis à 1 mais ne peut plus ensuite être remis à 0.

Les bits OTP trouvent diverses applications liées à la sécurisation de données dans les mémoires et sont généralement utilisés en tant que "jetons" consommables ou pour former des compteurs irréversibles. Par exemple, les bits OTP peuvent être utilisés pour autoriser l'accès à certaines zones mémoire pendant les étapes de personnalisation d'une carte à puce, puis sont tous mis à 1 lorsque la carte à puce est commercialisée afin de bloquer l'accès à des zones mémoire sensibles où se trouvent par exemple des codes secrets. L'irréversibilité de la programmation d'une cellule mémoire comprenant un bit OTP est donc une condition indispensable à l'obtention d'un certain degré de sécurité dans les circuits intégrés de carte à puce.

D'autre part, avec l'évolution des technologies et la miniaturisation de plus en plus poussée des circuits intégrés, il est devenu souhaitable d'équiper les mémoires EEPRCM d'un circuit permettant de détecter les erreurs intervenant dans le stockage des bits. De telles erreurs sont généralement dues à une altération des caractéristiques électriques rémanentes des cellules mémoires (tension de seuil), et sont plus fréquentes dans les mémoires de dernière génération comportant des transistors à grille flottante ayant des grilles très courtes inférieures à 0,35 micromètre. En pratique, une altération de la caractéristique électrique rémanente d'un cellule mémoire peut se traduire par la lecture d'un bit erroné, par exemple la lecture d'un bit à "0" alors qu'un bit à "1" avait été initialement enregistré.

Pour pallier cet inconvénient, les mémoires EEPROM sont équipées d'un circuit de correction d'erreur qui associe à chaque mot binaire enregistré un code de correction d'erreur, ou code ECC, généré par exemple au moyen de l'algorithme de Hamming bien connu de l'homme de l'art. Une telle méthode nécessite à chaque modification d'un bit d'un mot binaire l'enregistrement dans la mémoire d'un nouveau code ECC associé au mot binaire considéré. Cette opération s'avère toutefois impossible dans les zones mémoire contenant des bits OTP car l'enregistrement d'un nouveau code ECC nécessite généralement l'effacement et la programmation des cellules mémoire recevant le code, alors que les cellules mémoire d'une zone OTP ne peuvent être effacées.

La présente invention vise à pallier cet inconvénient, et vise notamment un moyen permettant de détecter et/ou corriger des erreurs de lecture dans la zone sécurisée non effaçable d'une mémoire.

Un autre objectif de la présente invention est de prévoir une mémoire comprenant à la fois une zone sécurisée OTP et un système de détection et/ou correction d'erreur qui couvre toute la mémoire.

Pour atteindre ces objectifs, une idée de la présente invention est de prévoir pour la zone OTP d'une mémoire un procédé de détection et/ou correction d'erreur qui ne nécessite pas pour être mis en oeuvre l'effacement de cellules mémoire.

Plus particulièrement, la présente invention se fonde sur la constatation qu'une technique de détection d'erreur par prévision d'une redondance d'octets dans une mémoire est applicable au "niveau bit" à des bits OTP car elle ne nécessite pas d'effacement de cellules mémoire lorsqu'elle est appliquée à des bits OTP. Ceci n'apparaît pas à première vue mais devient clair lorsqu'on considère un exemple concret. Ainsi, considérons par exemple une zone mémoire OTP qui ne comprend par défaut que des bits OTP à "0" (bits non utilisés ou non "consommés"). L'utilisation ou "consommation" d'un bit OTP se traduit par le fait de programmer N cellules mémoire (N bits OTP à "1") sans qu'il soit nécessaire d'effacer des cellules mémoire, car dans une mémoire de type EEPROM la programmation de cellules mémoire est faite individuellement. Une telle redondance de bits OTP selon l'invention peut être prévue avec ou sans entrelacement de bits OTP.

Ainsi, un premier aspect de la présente invention est de prévoir pour la zone OTP d'une mémoire un procédé de détection et/ou correction d'erreur de lecture basé sur une redondance de bits et sur la délivrance d'un signal d'erreur et/ou d'un bit de valeur majoritaire lorsque des bits redondants ne sont pas égaux.

Par contraste, la technique usuelle de protection des bits OTP contre les erreurs d'enregistrement est de démultiplier le nombre de bits OTP stockés dans une mémoire afin qu'au moins un bit OTP présente une valeur souhaitée, cette technique étant ainsi sans rapport avec une détection et/ou correction d'erreur fondée sur une comparaison des valeurs des bits redondants.

Le document US 5,999,447 illustre cette technique classique. Une zone OTP comprend un premier groupe de n bits OTP redondants et un second groupe de n bits OTP inversés redondants. Un circuit de lecture différentiel [DIFF-SENSE] représenté en figure 3 de ce document lit simultanément le premier groupe de bits redondants et le second groupe de bits inversés redondants, et délivre un bit et un seul ["BIT"]. Ce circuit de lecture différentiel n'est pas sensible à une notion de majorité et n'est également pas en mesure de délivrer un signal d'erreur. Il suffit qu'au moins une cellule mémoire soit passante pour qu'un courant circule dans l'amplificateur de lecture.

Suivant ce même principe, on connaît également par FR 2 687 811 une mémoire flash 2 divisée en secteurs dans laquelle chaque secteur comprend un champ de gestion d'effacement [11] comprenant une redondance de drapeaux de validation d'effacement [D7, D6] et une redondance de drapeaux indicateurs de secteurs défectueux [D5, D4]. Il n'y a pas, dans cette application, de notion de détection et/ou correction d'erreur ou de détermination d'une valeur majoritaire. Si par exemple la valeur significative d'un drapeau est "1", il suffit qu'au moins un drapeau soit à "1" dans un groupe de redondance pour que le drapeau soit considéré comme étant égal à "1".

Une autre idée de la présente invention est de prévoir pour la partie non OTP d'une mémoire un procédé de correction d'erreur de lecture utilisant des codes de correction d'erreur du type code de Hamming.

Encore une autre idée de la présente invention est de combiner dans une mémoire un premier circuit de détection et/ou correction d'erreur fonctionnant selon le principe de la redondance simple ou majoritaire et un second circuit de correction d'erreur utilisant des codes de correction d'erreur, en sélectionnant l'un ou l'autre de ces circuits en fonction de l'adresse appliquée à la mémoire, le premier circuit étant dédié à une zone OTP de la mémoire et le second dédié aux zones effaçables de la mémoire.

Ainsi, la présente invention prévoit une mémoire effaçable et programmable électriquement comprenant au moins une zone sécurisée programmable et non effaçable et une zone non sécurisée effaçable et programmable, et un premier circuit de détection et/ou correction d'erreur dédié à la zone sécurisée, comprenant des moyens de redondance pour enregistrer dans la zone sécurisée une pluralité de bits redondants, par une simple operation de programmation qui ne nécessite pas d'effacement des cellules mémoires, et des moyens de correction pour recevoir une pluralité de bits redondants selectionnés et lus dans la zone sécurisée et délivrer un signal d'erreur et/ou un bit de valeur majoritaire lorsque les bits redondants sélectionnés ne sont pas égaux.

Selon un mode de réalisation, la mémoire comprend un second circuit de correction d'erreur dédié à la zone effaçable et programmable de la mémoire, agencé pour enregistrer dans la mémoire des codes de correction d'erreur conjointement à l'enregistrement de bits de données, et détecter, le cas échéant, la présence d'un bit erroné dans une chaîne de bits lue dans la mémoire, et corriger le bit erroné.

Selon un mode de réalisation, la mémoire comprend un circuit de sélection agencé pour délivrer un signal de sélection du premier ou du second circuit de détection et/ou correction d'erreur, en fonction de la valeur d'une adresse appliquée à la mémoire.

Selon un mode de réalisation, le circuit de sélection est un circuit de protection de la zone sécurisée, agencé pour délivrer un signal d'inhibition d'une opération d'effacement lorsque l'adresse appliquée à la mémoire correspond à la zone sécurisée.

Selon un mode de réalisation, la mémoire comprend : dans les zones effaçables de la mémoire, des chaînes de M bits comprenant N1 bits de données et N2 bits de code de correction d'erreur, dans la zone sécurisée non effaçable, des chaînes de M bits comprenant M/N3 bits redondants, N3 étant un taux de redondance.

Selon un mode de réalisation, le premier circuit de détection et/ou correction d'erreur dédié à la zone sécurisée est agencé pour : lorsqu'un bit doit être programmé dans la zone sécurisée, programmer au moins deux bits égaux au bit à enregistrer, et lorsqu'un bit doit être lu dans la zone mémoire sécurisée, lire les bits redondants correspondant au bit à lire, et délivrer un signal d'erreur lorsque les bits redondants ne sont pas égaux.

Selon un mode de réalisation, le premier circuit de détection et/ou correction d'erreur dédié à la zone sécurisée est agencé pour : lorsqu'un bit doit être programmé dans la zone sécurisée, programmer au moins trois bits égaux au bit à enregistrer, et lorsqu'un bit doit être lu dans la zone mémoire sécurisée, lire les bits redondants correspondant au bit à lire, et délivrer un bit dont la valeur est majoritaire parmi les bits redondants lus.

Selon un mode de réalisation, le premier circuit de détection et/ou correction d'erreur dédié à la zone sécurisée est agencé pour entrelacer des bits redondants.

La présente invention concerne également un circuit intégré comprenant une mémoire effaçable et programmable électriquement selon l'invention, ainsi qu'un objet portatif électronique comprenant un circuit intégré comportant une mémoire effaçable et programmable électriquement selon l'invention.

Ces objets, caractéristiques et avantages ainsi que d'autres de la présente invention seront exposés plus en détail dans la description suivante d'une mémoire selon l'invention, faite à titre non limitatif en relation avec les figures jointes parmi lesquelles :

- la figure 1 représente l'architecture classique d'une mémoire EEPROM comprenant une zone sécurisée non effaçable,
- la figure 2 représente l'architecture classique d'une mémoire EEPROM comprenant un circuit de correction d'erreur,
- la figure 3 représente l'architecture d'une mémoire selon l'invention, comprenant une zone sécurisée non effaçable et un système de détection et/ou correction d'erreur,
- la figure 4 représente l'architecture d'un circuit de détection et/ou correction d'erreur selon l'invention représenté sous forme de bloc en figure 3,

- la figure 5 est le schéma logique d'un élément de correction d'erreur représenté sous forme de bloc en figure 4, et

- la figure 6 représente schématiquement une carte à puce comportant une mémoire selon l'invention.

### Rappels concernant les mémoires EEPROM comprenant une zone sécurisée non effaçable

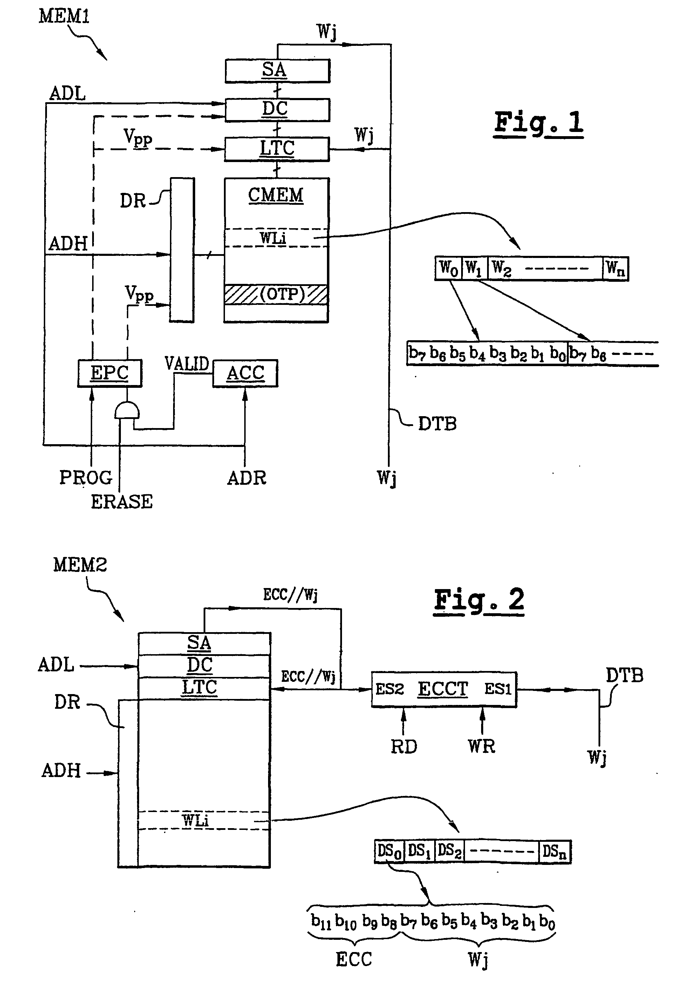

A titre de rappel, la figure 1 représente sous forme de blocs l'architecture classique d'une mémoire MEM1 comprenant une zone sécurisée non effaçable de type OTP. La mémoire MEM1 comprend un plan mémoire CMEM, un décodeur de ligne DR et un décodeur de colonne DC recevant respectivement les bits de poids fort ADH et les bits de poids faible ADL des adresses ADR appliquées à la mémoire, un circuit LTC de chargement de données, un circuit de lecture SA et un circuit EPC de contrôle des opérations d'effacement et de programmation du plan mémoire CMEM.

Le plan mémoire CMEM est composé classiquement de cellules mémoire agencées en lignes de mots $WL_i$ et en lignes de bits, les lignes de bits étant agencées en colonnes pour délimiter dans chaque ligne de mot $WL_i$ des mots binaires $W_0$ à $W_N$ comprenant chacun M bits, généralement des octets comprenant des bits b7 à b0. Le circuit LTC comprend une pluralité de verrous de programmation ("latchs") prévus pour mémoriser les bits d'un mot $W_j$ à enregistrer dans la mémoire. Le circuit SA comprend des amplificateurs de lecture ("sense amplifiers") pour lire les bits d'un mot $W_j$ sélectionné dans le plan mémoire CMEM. Le circuit EPC reçoit en entrée des signaux de programmation PROG et d'effacement ERASE de la mémoire et délivre au décodeur de ligne DR, au décodeur de colonne DC et au circuit DC une "haute" tension de programmation ou d'effacement Vpp de l'ordre de 15 à 20V.

Lorsqu'un mot binaire $W_j$ doit être enregistré dans la mémoire, l'adresse ADR d'enregistrement du mot est appliquée à la mémoire. Les bits b7 à b0 du mot $W_j$ sont chargés dans les verrous circuit LTC et le signal ERASE est appliqué tout d'abord au circuit EPC qui envoie alors au décodeur de ligne DR la tension Vpp d'effacement des cellules désignées par l'adresse ADR. Le signal de programmation PROG est ensuite appliqué au circuit EPC qui envoie au décodeur de colonne DC et aux verrous LTC la tension de programmation Vpp.

En résumé, l'enregistrement d'un mot $W_j$ comprend ainsi une étape d'effacement collectif des cellules désignées par l'adresse ADR, qui sont mises à 0 (le "0" étant ici choisi par convention pour désigner l'état effacé) suivie d'une étape de programmation individuelle des cellules devant contenir des bits à "1" du nouveau mot $W_j$, ces cellules étant automatiquement sélectionnées par les verrous du circuit LTC.

Dans une telle mémoire, une zone sécurisée non effaçable de type OTP est obtenue de façon simple au moyen d'un circuit de contrôle d'adresse ACC recevant en entrée les adresses ADR appliquée à la mémoire et délivrant un signal VALID de validation des opérations d'effacement. Le signal VALID est par exemple mis à 0 par le circuit ACC quand une adresse correspondant à la zone OTP est appliquée à la mémoire, ce qui inhibe l'application du signal ERASE au circuit EPC, comme représenté schématiquement sur la figure 1 par une porte ET recevant en entrée les signaux ERASE et VALID, dont la sortie délivre le signal ERASE au circuit EPC.

### Rappels concernant les mémoires EEPROM comprenant un circuit de correction d'erreur

Toujours à titre de rappel, la figure 2 représente sous forme de blocs l'architecture d'une mémoire MEM2 qui se distingue de la mémoire MEM1 en ce qu'elle comprend un circuit de correction d'erreur ECCT et ne comprend pas de zone sécurisée. Le circuit ECCT présente une entré/sortie ES1 connectée au bus de données DTB de la mémoire et une entrée/sortie ES2 connectée à l'entrée du circuit LTC et à la sortie du circuit SA (par la suite, une entrée/sortie sera désignée "entrée" ou "sortie" selon le contexte de la description). Le circuit ECCT reçoit un signal RD ("Read") qui est à 1 pendant les phases de lecture de la mémoire et un signal WR ("Write") qui est à 1 pendant les phases d'effacement ou programmation.

Lorsqu'un mot $W_j$ doit être enregistré dans la mémoire (WR=1), le mot est appliqué sur l'entrée ES1 du circuit ECCT dont la sortie ES2 délivre le mot $W_j$ concaténé avec un code de correction d'erreur $ECC_j$. L'ensemble concaténé $ECC_j//W_j$ forme une chaîne de bits $DS_j$ qui est chargée dans le circuit LTC pour être enregistrée dans le plan mémoire CMEM. Le code $ECC_j$ est par exemple un code de Hamming de quatre bits permettant de détecter et de corriger un bit erroné parmi douze, de sorte que la chaîne de bits $DS_j$ comprend douze bits :

$$Es_j = b11\ b10\ b9\ b8\ b7\ b6\ b5\ b4\ b3\ b2\ b1\ b0$$

parmi lesquels les bits b11 à b8 forment le code $ECC_j$ et les bits b7 à b0 forment le mot Wj.

La mémoire MEM2 se distingue donc de la précédente en ce que les lignes de mots $WL_i$ du plan mémoire CMEM comprennent des chaînes de bits $DS_j$ ($DS_0$ à $DS_N$) comprenant chacune un mot binaire $W_j$ et un code $ECC_j$. Ainsi, lorsqu'une chaîne de bits $DS_j$ est lue dans la mémoire par le circuit SA (RD=1) , le circuit ECCT reçoit la chaîne de bits $DS_j$ sur son entrée ES2 et délivre sur sa sortie ES1 les huit bits de données b7-b0 contenus dans la chaîne $DS_j$, en corrigeant l'un de ces bits si une erreur de lecture est détectée.

Comme on l'a indiqué au préambule, la prévision dans une telle mémoire d'une zone sécurisée non effaçable se heurte au fait que l'enregistrement d'une chaîne de bits comprenant des codes ECC ne peut être fait sans effacement préalable des cellules d'accueil, un code de correction d'erreur pouvant comprendre des bits à 1 ou à 0 qui sont sans relation avec les bits du code précédemment enregistré. L'intégration dans une mémoire d'un circuit de correction d'erreur tel le circuit ECCT est ainsi incompatible avec la prévision d'un zone OTP non effaçable.

## Description d'une mémoire selon l'invention

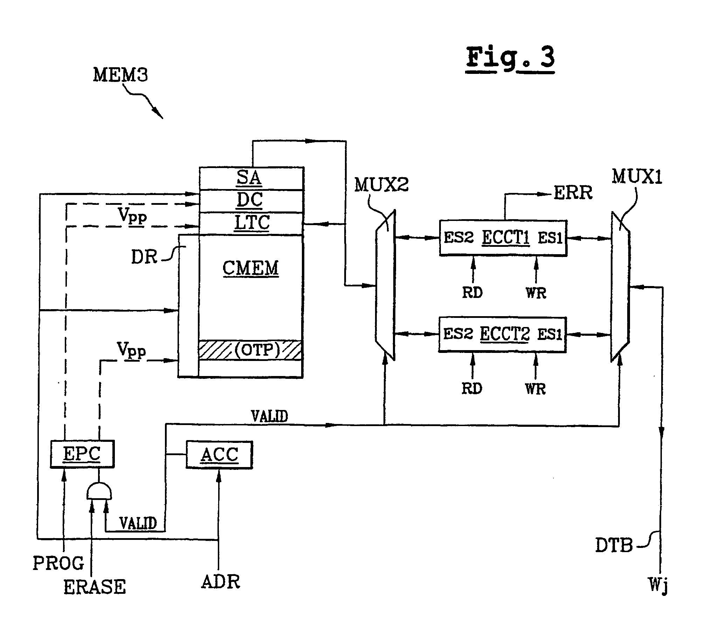

La figure 3 illustre une mémoire MEM3 selon l'invention qui pallie l'inconvénient mentionné ci-dessus. La structure générale de la mémoire MEM3 est conforme à celles des mémoires MEM1 et MEM2 et ne sera pas décrite à nouveau. On suppose ici que le plan mémoire CMEM de la mémoire MEM3 comprend, comme celui de la mémoire MEM2, des chaînes de bits $DS_j$ de 12 bits chacune.

La mémoire MEM3 se distingue des mémoires MEM1, MEM2 en ce qu'elle présente à la fois une zone sécurisée OTP et un système de correction d'erreur couvrant tout le plan mémoire CMEM, y compris la zone OTP. Cette zone OTP est protégée en effacement de façon classique par un circuit de contrôle d'adresse ACC délivrant le signal VALID qui inhibe ou valide les opérations d'effacement (signal ERASE) selon qu'une adresse ADR appliquée à la mémoire correspond ou non à la zone OTP.

Selon l'invention, la mémoire MEM3 comprend un premier circuit de correction d'erreur ECCT1 dédié à la gestion des erreurs de lecture dans la zone OTP, et un deuxième circuit de correction d'erreur ECCT2 agencé en parallèle avec le premier, dédié à la gestion des erreurs de lecture dans le reste du plan mémoire CMEM. Chacun des circuits ECCT1, ECCT2 comprend deux entrées/sorties ES1, ES2 et reçoit un signal RD à 1 pendant les périodes de lecture de la mémoire et un signal WR à 1 pendant les périodes d'écriture. L'entrée/sortie ES1 de chaque circuit est connectée au bus de données DTB de la mémoire par l'intermédiaire d'un multiplexeur MUX1, et l'entrée/sortie ES2 est connectée au circuit de chargement de données LTC et au circuit de lecture SA par l'intermédiaire d'un multiplexeur MUX2. Les multiplexeurs MUX1, MUX2 reçoivent sur leur entrée de sélection le signal VALID délivré par le circuit de contrôle d'adresse ACC et sont agencés pour sélectionner l'un ou l'autre des deux circuits ECCT1, ECCT2 selon la valeur de ce signal.

Ainsi, lorsqu'une adresse ADR appliquée à la mémoire désigne une chaîne de bits qui se trouve dans la zone OTP, le circuit ECCT1 a son entrée/sortie ES1 connectée au bus de données DTB et son entrée/sortie ES2 connectée aux circuits LTC, SA. Inversement, lorsque l'adresse appliquée ADR ne correspond pas à la zone OTP, c'est le circuit ECCT2 qui a ses entrées/sorties ES1, ES2 connectées au bus de données DTB et aux circuits LTC, SA.

Le circuit ECCT2 est un circuit de correction d'erreur classique conforme au circuit ECCT décrit plus haut. Ainsi, en mode écriture de la mémoire (WR=1), le circuit ECCT2 délivre sur sa sortie ES2 des chaînes de bits comprenant huit bits de données b7-b0 recopiant un mot binaire $W_j$ reçu sur l'entrée ES1 et quatre bits b11-b8 formant un code de correction d'erreur, par exemple un code de Hamming. En mode lecture de la mémoire (RD=1), le circuit ECCT2 reçoit sur son entrée ES2 une chaîne de bits comprenant un code ECC et huit bits de données b7-b0, qui sont délivrés sur la sortie ES1 éventuellement après correction d'un bit si une erreur de lecture est détectée.

Le circuit ECCT1 fonctionne selon un principe de correction d'erreur différent, basé sur une redondance de bits sans codage. En mode écriture de la mémoire (WR=1), le circuit ECCT1 délivre sur sa sortie ES2 des bits recopiant de façon redondante les bits reçus sur l'entrée ES1. Le plan mémoire CMEM étant prévu ici pour enregistrer des chaînes de douze bits, le taux de redondance du circuit ECCT1 est par exemple choisi égal à 3 pour former trois groupes de quatre bits. Ainsi, le circuit ECCT1 duplique 4 bits b3 à b0 reçus sur l'entrée ES1 en douze bits b12' à b0' délivrés sur la sortie ES2, liés aux bits b3 à b0 par les relations suivantes :

$$b8' = b4' = b0' = b0$$

$$b9' = b5' = b1' = b1$$

$$b10' = b6' = b2' = b2$$

$$b11' = b7' = b3' = b3$$

qui définissent une triple redondance avec entrelacement des bits redondants b11' à b0'. Les bits b11' à b0' sont ensuite chargés dans des verrous du circuit LTC puis sont enregistrés dans la mémoire par une simple opération de programmation qui ne nécessite pas d'effacement des cellules mémoires si les règles de manipulation des bits OTP sont respectées.

A titre d'exemple, supposons que la zone OTP comprenne une chaîne de bits égale à :

$$DS_j = 111\underline{0}111\underline{0}111\underline{0}$$

En éliminant les redondances, cette chaîne de bits est équivalente à quatre jetons dont trois ont été "utilisés" (bits à 1), un jeton restant disponible (bit à 0) :

111$\underline{0}$

Pour "utiliser" le dernier jeton, le mot "1111" est placé à l'entrée ES1 du circuit ECCT1 qui délivre alors sur sa sortie ES2 la chaîne redondante suivante :

DSj' = 111111111111

Cette chaîne de bits DSj' est chargée dans les verrous correspondants du circuit LTC et est enregistrée à la place de la chaîne de bits précédente DSj. Cette opération ne comprend que l'enregistrement de trois "1" à la place des trois "0" précédents, et ne nécessite qu'une étape de programmation des cellules correspondantes sans effacement de la chaîne de bits précédente. Ainsi, il apparaît clairement que l'enregistrement de bits OTP redondants ne pose aucun problème dans une zone OTP non effaçable.

En mode lecture de la mémoire (RD=1), le circuit ECCT1 reçoit en entrée ES2 une chaîne de bits redondants b11'-b0' délivrée par le circuit de lecture SA et délivre sur la sortie ES1 les quatre bits initiaux b3-b0. Une erreur de lecture sur un bit se traduit par une inégalité entre les trois bits redondants et le bit délivré sur la sortie ES1 est celui qui est majoritaire sur les trois bits lus. Supposons à titre d'exemple que la chaîne de bits suivante soit délivrée par le circuit de lecture SA sur l'entrée ES1 du circuit ECCT1 :

$DS_j$ = 011101100110

Cette chaîne de bits comprend une erreur de lecture car trois bits qui devraient être égaux (bits soulignés) ne le sont pas. Le circuit ECCT1 délivre alors sur sa sortie ES1 les bits suivants :

0110

avec le quatrième bit égal à "0" car le "0" est majoritaire dans les trois bits redondants. Le circuit ECCT1 délivre en outre un signal d'erreur ERR indiquant qu'au moins un bit lu est erroné.

### Exemple de réalisation du circuit ECCT1

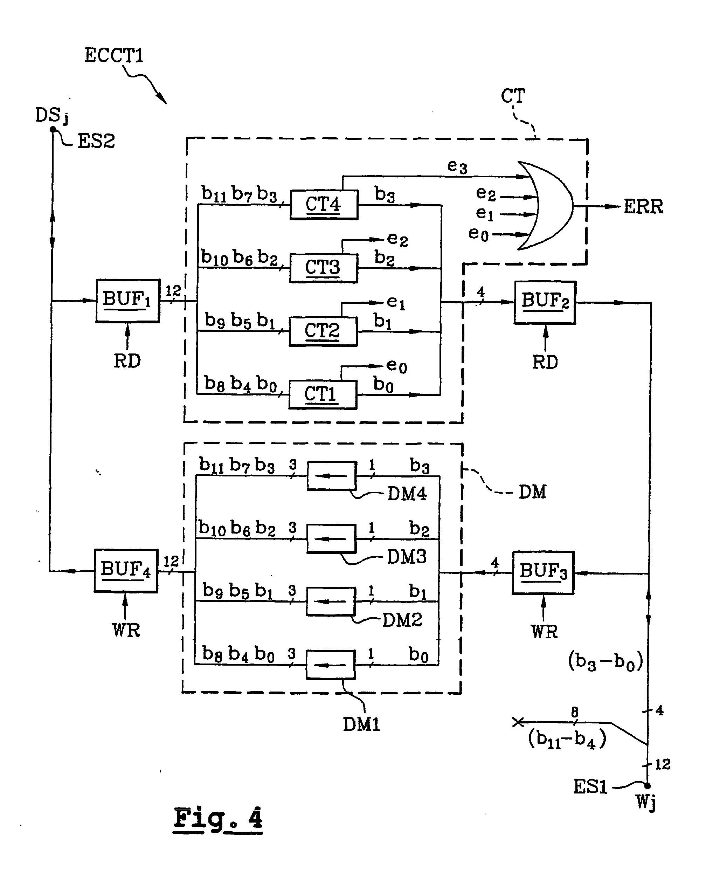

La figure 4 représente un mode de réalisation du circuit ECCT1. Le circuit ECCT1 comprend un bloc de correction CT et un bloc de redondance DM. Le bloc de correction CT est connecté à l'entrée ES2 par l'intermédiaire d'un tampon BUF1 et est connecté à la sortie ES1 par l'intermédiaire d'un tampon BUF2, les tampons BUF1, BUF2 étant transparents lorsque le signal RD est à 1. Le bloc de redondance DM est connecté à l'entrée ES1 par l'intermédiaire d'un tampon BUF3 et est connecté à la sortie ES2 par l'intermédiaire d'un tampon BUF4, les tampons BUF3, BUF4 étant transparents lorsque le signal WR est à 1.

Le bloc DM comprend quatre démultiplexeurs DM1 à DM4 présentant chacun une entrée et trois sorties, les trois sorties étant agencées pour recopier simultanément la valeur d'un bit présenté en entrée. Le circuit DM1 reçoit en entrée le bit b0 d'une chaîne de bits appliquée sur l'entrée ES1 et délivre les bits redondants b8', b4', b0'. Le circuit DM2 reçoit en entrée le bit b1 et délivre les bits b9', b5', b1'. Le circuit DM3 reçoit le bit b2 et délivre les bits b10', b6', b2' et le circuit DM4 reçoit le bit b3 et délivre les bits b11', b7', b3'. Les huit autres bits présents sur l'entrée ES1 ne sont pas utilisés, les pistes conductrices correspondantes du bus de données n'étant pas connectées au circuit ECCT1.

Le bloc CT comprend quatre circuits de correction d'erreur CT1 à CT4 recevant chacun trois bits redondants sélectionnés dans une chaîne de bits b11 à b0 délivrée par le circuit de lecture SA et appliquée sur l'entrée ES2. Il s'agit respectivement des bits {b8', b4' et b0'}, {b9' b5' b1'}, {b10' b6' b2'}, {b11' b7' b3'}. Les blocs CT1 à CT4 délivrent un bit corrigé, respectivement b0, b1, b2, b3, appliqué sur la sortie ES1 par l'intermédiaire du tampon BUF2. Chaque circuit CT1 à CT4 délivre par ailleurs un bit d'erreur, respectivement e0 à e3, lorsque trois bits redondants présentés en entrée ne sont pas égaux. Les bits d'erreur sont combinés dans un porte OU pour former le signal d'erreur ERR délivré par le circuit ECCT1.

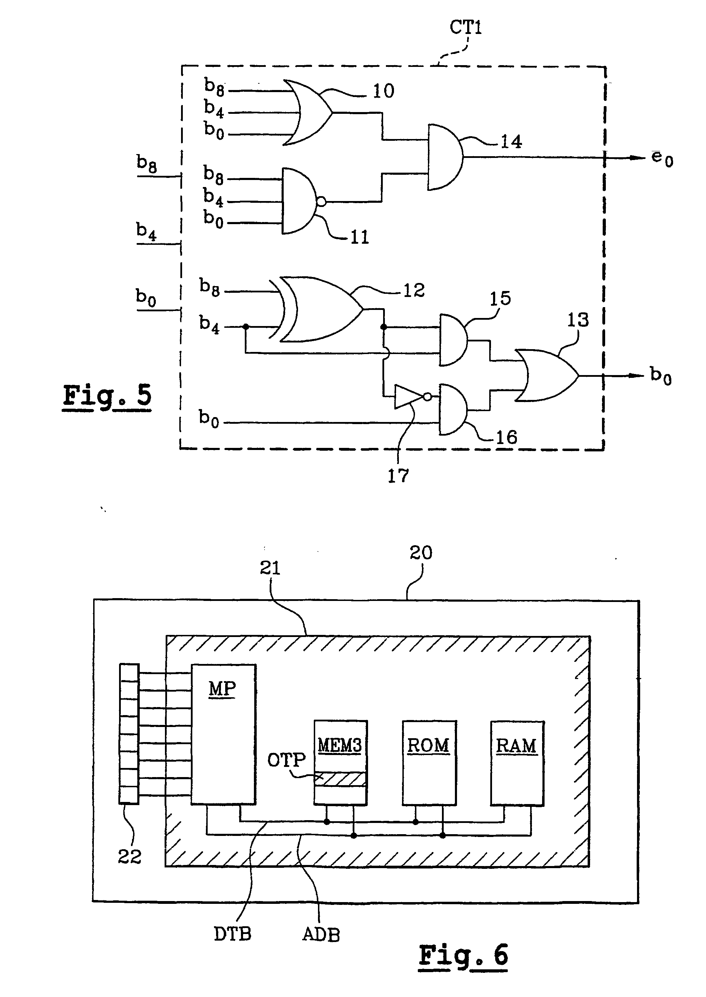

La figure 5 représente un exemple de réalisation du circuit correcteur CT1, sous la forme d'un circuit logique. Le circuit CT1 comprend une porte "OU" 10 à trois entrées, une porte "NON ET" 11 à trois entrées, une porte "OU Exclusif" 12 à deux entrées ("⊕"), une porte "OU" 13 à deux entrées, une porte "ET" 14 à deux entrées, une porte "ET" 15 à deux entrées, une porte "ET" 16 à deux entrées et une porte inverseuse 17 ("INV"). Ces diverses portes sont agencées pour délivrer le bit de donnée b0 et le bit d'erreur e0 conformément aux relations suivantes :

b0 = [(b8 ⊕ b4) ET b4] OU [INV(b8 ⊕ b4) ET b0]

e0 = [INV(b0 ET b4 ET b8)] ET [b0 OU b4 OU b8]

Les autres circuits CT2, CT3, CT4 étant de même structure que le circuit CT1, ils ne seront pas décrits. Ils se distinguent du circuit CT1 par le rang des bits reçus en entrée et par le rang du bit délivré.

### Variantes et applications de l'invention

La présente invention est bien entendu susceptible de diverses variantes et modes de réalisation. En particulier, bien que l'on ait décrit dans ce qui précède un circuit ECCT1 qui assure une correction d'erreur par redondance majoritaire, un mode de réalisation consiste à prévoir un circuit ECCT1 assurant uniquement une détection d'erreur sans correction de bit. Dans ce cas, le circuit ECCT1 peut fonctionner selon le principe de la redondance simple, un bit reçu sur l'entrée ES1 étant dupliqué en deux bits seulement sur la sortie ES2, par exemple comme indiqué ci-après :

b6'= b0' = b0

$$b7' = b1' = b1$$

$$b8' = b2' = b2$$

$$b9' = b3' = b3$$

$$b10' = b4' = b4$$

$$b11' = b5' = b5$$

Dans ce cas, le circuit ECCT1 ne résout pas les conflits entre deux bits redondants et se borne à délivrer le signal d'erreur ERR quand deux bits redondants ne sont pas égaux. Le signal d'erreur ERR est détecté par le gestionnaire de la mémoire, par exemple un microprocesseur, qui peut être programmé pour se bloquer définitivement quand le signal d'erreur ERR est émis. On considère dans ce cas que la mémoire n'est pas valable et que le circuit dans laquelle elle est intégrée doit être détruit.

D'autre part, bien que l'on ait proposé plus haut un entrelacement des bits redondants, une redondance de bits non entrelacés peut également être prévue, par exemple comme suit :

$$b2' = b1' = b0' = b0$$

$$b5' = b4' = b3' = b1$$

$$b8' = b7' = b6' = b2$$

$$b11' = b10' = b9' = b3$$

Egalement, bien que l'on ait décrit dans ce qui précède une combinaison avantageuse d'un circuit de détection et/ou correction d'erreur ECCT1 fonctionnant selon le principe de la redondance simple ou majoritaire et d'un circuit de correction d'erreur ECCT2 utilisant des codes de correction d'erreur, il va de soi que l'application à une zone sécurisée non effaçable du circuit ECCT1 constitue un aspect essentiel de l'invention indépendant de la combinaison proposée, de sorte que le circuit ECCT1 peut être mis en oeuvre sans le circuit ECCT2. Le circuit ECCT1 peut également être mis en oeuvre en combinaison avec tout autre type de circuit de correction d'erreur.

Egalement, il découle de ce qui précède que la présente invention est applicable à tous types de mémoires effaçables et programmables électriquement comprenant une zone sécurisée non effaçable, notamment les mémoires FLASH.

Enfin, une mémoire selon l'invention est susceptible de diverses applications. Elle peut notamment être intégrée sur une plaquette de silicium isolément ou en association avec d'autres éléments. A titre d'exemple, la figure 6 représente très schématiquement une carte à puce 20 comprenant un circuit intégré 21 et des contacts 22, par exemple huit contacts ISO 7816. Le circuit intégré 21 comprend un microprocesseur MP, une mémoire MEM3 selon l'invention, une mémoire morte ROM et une mémoire vive RAM, ces divers éléments étant connectés à un bus de données DTB et à un bus d'adresse ADB. Le microprocesseur MP comprend en outre des ports d' entrée/sortie connectés aux contacts 22.

Dans une telle application, la zone OTP de la mémoire MEM3 peut être utilisée pendant les étapes de personnalisation de la carte 20 pour la gestion des accès à certaines zones des mémoires MEM3, ROM ou RAM. Lorsque la carte 20 est mise en service, tous les bits OTP sont portés à 1 de sorte que l'accès aux zones de personnalisation de la carte est définitivement verrouillé.

## Revendications

1. Mémoire (MEM3) effaçable et programmable électriquement comprenant au moins une zone (OTP) sécurisée programmable et non effaçable et une zone non sécurisée effaçable et programmable, **caractérisée en ce qu'**elle comprend un premier circuit (ECCT1) de détection et/ou correction d'erreur dédié à la zone sécurisée (OTP), comprenant des moyens de redondance (DM) pour enregistrer dans la zone sécurisée une pluralité de bits redondants (b11'-b0' ) par une simple operation de programmation qui ne nécessite pas d'effacement des cellules mémoires, et des moyens de correction (CT) pour recevoir une pluralité de bits redondants selectionnés (b8, b4, b0) et lus dans la zone sécurisée et délivrer un signal d'erreur (e0) et/ou un bit de valeur majoritaire (b0) lorsque les bits redondants selectionnés ne sont pas égaux.

2. Mémoire selon la revendication 1, **caractérisée en ce qu'**elle comprend un second circuit de correction d'erreur (ECCT2) dédié à la zone effaçable et programmable de la mémoire, agencé pour enregistrer dans la mémoire des codes de correction d'erreur (ECC, b11-b8) conjointement à l'enregistrement de bits de données (b7-b0), et détecter, le cas échéant, la présence d'un bit erroné dans une chaîne de bits (DSj) lue dans la mémoire, et corriger le bit erroné.

3. Mémoire selon la revendication 2, **caractérisée en ce qu'**elle comprend un circuit de sélection (ACC) agencé pour délivrer un signal de sélection (VALID) du premier (ECCT1) ou du second (ECCT2) circuit de détection et/ou correction d'erreur, en fonction de la valeur d'une adresse (ADR) appliquée à la mémoire.

4. Mémoire selon la revendication 3, **caractérisée en ce que** le circuit de sélection est un circuit (ACC) de protection de la zone sécurisée, agencé pour délivrer un signal (VALID) d'inhibition d'une opération d'effacement (ERASE) lorsque l'adresse appliquée à la mémoire correspond à la zone sécurisée.

5. Mémoire selon l'une des revendications 2 à 4, **caractérisée en ce qu'**elle comprend :

   - dans les zones effaçables de la mémoire, des chaînes (DSj) de M bits comprenant N1 bits de données (b7-b0) et N2 bits de code de correction d'erreur (b11-b8),
   - dans la zone sécurisée non effaçable, des chaînes (DSj) de M bits (b11'-b0') comprenant M/N3 bits redondants (b3'-b0'), N3 étant un taux de redondance.

6. Mémoire selon l'une des revendications 1 à 5, **caractérisée en ce que** le premier circuit (ECCT1) de détection et/ou correction d'erreur dédié à la zone sécurisée est agencé pour :

   - lorsqu'un bit doit être programmé dans la zone sécurisée, programmer au moins deux bits égaux au bit à enregistrer, et
   - lorsqu'un bit doit être lu dans la zone mémoire sécurisée, lire les bits redondants correspondant au bit à lire, et délivrer un signal d'erreur (ERR) lorsque les bits redondants ne sont pas égaux.

7. Mémoire selon l'une des revendications 1 à 5, **caractérisée en ce que** le premier circuit (ECCT1) de détection et/ou correction d'erreur dédié à la zone sécurisée est agencé pour :

   - lorsqu'un bit doit être programmé dans la zone sécurisée, programmer au moins trois bits égaux au bit à enregistrer, et
   - lorsqu'un bit doit être lu dans la zone mémoire sécurisée, lire les bits redondants correspondant au bit à lire, et délivrer un bit dont la valeur est majoritaire parmi les bits redondants lus.

8. Mémoire selon l'une des revendications 1 à 7, **caractérisée en ce que** le premier circuit (ECCT1) de détection et/ou correction d'erreur dédié à la zone sécurisée est agencé pour entrelacer des bits redondants.

9. Circuit intégré (21), **caractérisé en ce qu'**il comprend une mémoire effaçable et programmable électriquement selon l'une des revendications 1 à 8.

10. Objet portatif électronique (20), **caractérisé en ce qu'**il comprend un circuit intégré comportant une mémoire effaçable et programmable électriquement selon l'une des revendications 1 à 8.

**Claims**

1. Electrically erasable and programmable memory (MEM3) comprising at least one programmable and non-erasable secured area (OTP) and a non-secured erasable and programmable area, **characterised in that** it comprises a first error detection and/or correction circuit (ECCT1) dedicated to the secured area (OTP), comprising redundancy means (DM) for recording, in the secured area, a plurality of redundant bits (b 11' - b0') by a simple programming operation which does not require erasing any memory cells, and correction means (CT) for receiving a plurality of redundant bits (b8, b4, b0) which are selected and read in the secured area, and for delivering an error signal (e0) and/or a majority value bit (b0) when the selected redundant bits are not equal.

2. Memory according to claim 1, **characterised in that** it comprises a second error correction circuit (ECCT2) dedicated to the erasable and programmable area of the memory, used to record, in the memory, error correction codes (ECC, b 11-b8) and at the same time the recording of data bits (b7-b0), and to detect, where necessary, the presence of an erroneous bit in a bit stream (DSj) read in the memory, and to correct the erroneous bit.

3. Memory according to claim 2, **characterised in that** it comprises a selection circuit (ACC) used to deliver a selection signal (VALID) from the first (ECCT1) or second (ECCT2) error detection and/or correction circuit according to the address value (ADR) applied to the memory.

4. Memory according to claim 3, **characterised in that** the selection circuit is a circuit (ACC) for protecting the secured area, used to deliver a signal (VALID) for inhibiting an erasing operation (ERASE) when the address applied to the memory corresponds to the secured area.

5. Memory according to one of claims 2 to 4, **characterised in that** it comprises :

   - in the erasable areas of the memory, streams (DSj) of M bits comprising N1 data bits (b7-b0) and N2 code bits for correcting errors (b11-b8),

- in the non-erasable area, streams (DSj) of M bits (b11' - b0') comprising M/N3 redundant bits (b3' - b0'), N3 being the redundancy rate.

6. Memory according to one of claims 1 to 5, **characterised in that** the first error detection and/or correction circuit (ECCT1) dedicated to the secured area is used to :

- program at least two bits equal to the bit to be recorded, when a bit has to be programmed in the secured area, and
- read the redundant bits corresponding to the bit to be read, when a bit has to be read in the secured area, and deliver an error signal (ERR) when the redundant bits are not equal.

7. Memory according to one of claims 1 to 5, **characterised in that** the first error detection and/or correction circuit (ECCT1) dedicated to the secured area is used to :

- program at least three bits equal to the bit to be recorded, when a bit has to be programmed in the secured area, and
- read the redundant bits corresponding to the bit to be read, when a bit has to be read in the secured area, and deliver a bit with a majority value from the redundant bits which have been read.

8. Memory according to one of claims 1 to 7, **characterised in that** the first error detection and/or correction circuit (ECCT1) dedicated to the secured area is used to interlace redundant bits.

9. Integrated circuit (21), **characterised in that** it comprises an electrically erasable and programmable memory according to one of claims 1 to 8.

10. Electronic portable object (20), **characterised in that** it comprises an integrated circuit comprising an electrically erasable and programmable memory according to one of claims 1 to 8.

**Patentansprüche**

1. Elektrisch löschbare und programmierbare Speichervorrichtung (MEM3), umfassend mindestens einen gesicherten, programmierbaren und nicht löschbaren Bereich (OTP) und einen nicht gesicherten löschbaren und programmierbaren Bereich, **dadurch gekennzeichnet, dass** sie eine erste Schaltung (ECCT1) zur Erfassung und/oder Korrektur von Fehlern umfasst, die für den gesicherten Bereich (OTP) vorgesehen ist, umfassend redundante Mittel (DM) zum Speichern einer Vielzahl von redundanten Bits (b11' - b0') in dem gesicherten Bereich über einen einfachen Programmiervorgang, für den kein Löschen von Speicherzellen erforderlich ist, und Korrekturmittel (CT) zum Aufnehmen einer Vielzahl von ausgewählten und in dem gesicherten Bereich gelesenen redundanten Bits (b8, b4, b10) und zum Liefern eines Fehlersignals (e0) und/oder eines höherwertigen Bits (b0), wenn die ausgewählten redundanten Bits nicht gleich sind.

2. Speichervorrichtung nach Anspruch 1, **dadurch gekennzeichnet, dass** sie eine zweite Schaltung zur Fehlerkorrektur (ECCT2) umfasst, die für den löschbaren und programmierbaren Bereich der Speichervorrichtung vorgesehen ist, wobei sie zum Speichern von Fehlerkorrekturcodes (ECC, b11 - b8) sowie zum gleichzeitigen Speichern von Datenbits in der Speichervorrichtung, und erforderlichenfalls zum Erfassen des Vorhandenseins eines fehlerhaften Bits in einer Bitkette (DSj), die aus der Speichervorrichtung ausgelesen wird, und zum Korrigieren des fehlerhaften Bits ausgelegt ist.

3. Speichervorrichtung nach Anspruch 2, **dadurch gekennzeichnet, dass** sie eine Auswahlschaltung (ACC) umfasst, die zum Liefern eines Auswahlsignals (VALID) der ersten (ECCT1) oder der zweiten (ECCT2) Schaltung zur Erfassung und/oder Korrektur von Fehlern in Abhängigkeit von dem Wert einer Adresse (ADR) ausgelegt ist, die auf die Speichervorrichtung angewendet wird.

4. Speichervorrichtung nach Anspruch 3, **dadurch gekennzeichnet, dass** die Auswahlschaltung eine Schutzschaltung (ACC) für den gesicherten Bereich ist, die zum Liefern eines Signals (VALID) zum Sperren eines Löschvorgangs (ERASE) ausgelegt ist, wenn die auf die Speichervorrichtung angewendete Adresse dem gesicherten Bereich entspricht.

5. Speichervorrichtung nach einem der Ansprüche 2 bis 4, **dadurch gekennzeichnet, dass** sie folgendes umfasst:

- Ketten (DSj) von M Bits mit N1 Datenbits (b7 - b0) und N2 Fehlerkorrekturcode-Bits (b11 - b8) in den löschbaren Bereichen der Speichervorrichtung,

- Ketten (DSj) von M Bits (b11' - b0') mit M/N3 redundanten Bits (b3' - b0') in den nicht löschbaren Bereichen der Speichervorrichtung, wobei N3 eine Redundanzrate ist.

6. Speichervorrichtung nach einem der Ansprüche 1 bis 5, **dadurch gekennzeichnet, dass** die erste Schaltung zur Erfassung (ECCT1) und/oder Korrektur von Fehlern, die für den gesicherten Bereich vorgesehen ist, für folgendes ausgelegt ist:

- zum Programmieren von wenigstens zwei mit dem zu speichernden Bit gleichen Bits, wenn ein Bit in dem gesicherten Bereich programmiert werden soll, und
- zum Lesen der redundanten Bits, die dem zu lesenden Bit entsprechen, und zum Liefern eines Fehlersignals (ERR), wenn die redundanten Bits nicht gleich sind, wenn ein Bit in dem gesicherten Speicherbereich gelesen werden soll.

7. Speichervorrichtung nach einem der Ansprüche 1 bis 5, **dadurch gekennzeichnet, dass** die erste Schaltung zur Erfassung (ECCT1) und/oder Korrektur von Fehlern, die für den gesicherten Bereich vorgesehen ist, für folgendes ausgelegt ist:

- zum Programmieren von wenigstens drei mit dem zu speichernden Bit gleichen Bits, wenn ein Bit in dem gesicherten Bereich programmiert werden soll, und

- zum Lesen der redundanten Bits, die dem zu lesenden Bit entsprechen, und zum Liefern eines Bits, dessen Wert gegenüber den gelesenen redundanten Bits höherwertiger ist, wenn ein Bit in dem gesicherten Speicherbereich gelesen werden soll.

8. Speichervorrichtung nach einem der Ansprüche 1 bis 7, **dadurch gekennzeichnet, dass** die erste Schaltung zur Erfassung (ECCT1) und/oder Korrektur von Fehlern, die für den gesicherten Bereich vorgesehen ist, zum Verschachteln der redundanten Bits ausgelegt ist.

9. Integrierter Schaltkreis (21), **dadurch gekennzeichnet, dass** er eine elektrisch löschbare und programmierbare Speichervorrichtung nach einem der Ansprüche 1 bis 8 umfasst.

10. Tragbares elektronisches Objekt (20), **dadurch gekennzeichnet, dass** es einen integrierten Schaltkreis umfasst, der eine elektrisch löschbare und programmierbare Speichervorrichtung nach einem der Ansprüche 1 bis 8 enthält.

_Fig. 1_

_Fig. 2_

Fig. 3

**Fig. 4**

CT1

$b_8$
$b_4$
$b_0$

10

14 → $e_0$

$b_8$

$b_8$
$b_4$
$b_0$

11

$b_4$

$b_0$

$b_8$

12

15

13

$b_4$

$b_0$

$b_0$ → $b_0$

16

17

**Fig. 5**

20

21

MP

OTP

MEM3

ROM

RAM

22

DTB    ADB

**Fig. 6**

14